# EUROPÄISCHE PATENTSCHRIFT

(11) **EP 2 328 390 B1**
(45) Veröffentlichungstag und Bekanntmachung des Hinweises auf die Patenterteilung: **31.08.2016**
(21) Anmeldenummer: 10014503.6
(22) Anmeldetag: 11.11.2010
(51) Int. Cl.: H05K 1/02, H02M 7/00, H05K 7/20

(54) **Umrichter mit einem Kühlkörper**
Converter with a cooling unit
Convertisseur avec dissipateur thermique

(30) Priorität: 19.11.2009 DE 102009053999
(43) Veröffentlichungstag der Anmeldung: 01.06.2011
(73) Patentinhaber: STILL GmbH, 22113 Hamburg (DE)
(72) Erfinder: Wilhoeft, Adolf, 22885 Barsbüttel (DE); Schmidt, Niels, 22885 Barsbüttel (DE); Schettgen, Nils Christoph, 22609 Hamburg (DE)
(74) Vertreter: Geirhos, Johann

(56) Entgegenhaltungen:
- WO-A1-2006/027040
- WO-A2-03/034467
- DE-A1- 19 528 632
- DE-A1- 19 630 173
- DE-A1- 19 942 915
- US-A1- 2004 164 388
- US-A1- 2009 168 358
- US-A1- 2009 261 472

## Beschreibung

Die Erfindung betrifft einen Umrichter, insbesondere mehrphasiger Drehstromumrichter, mit einem mindestens einen Leistungshalbleiter aufweisenden Leistungsmodul und einem Kühlkörper, wobei das Leistungsmodul von einer Leiterplatte gebildet sind, die mit einer den Leistungshalbleitern gegenüberliegenden Seite an einem Kühlkörper anliegt und mittels mindestens eines Befestigungsmittels, insbesondere einer Verschraubung, mit dem Kühlkörper in thermischen Kontakt bringbar und an dem Kühlkörper befestigt ist.

Derartige mehrphasige Umrichter, beispielsweise dreiphasige Wechselrichter oder Frequenzumrichter, werden zur Speisung von elektrischen Antriebsmaschinen aus einer Gleichspannungsquelle verwendet. Eingesetzt werden derartige Umrichter beispielsweise als Frequenzumrichter, die aus einer Gleichspannungsquelle einen Fahrmotor, beispielsweise einen Asynchronmotor, eines mobilen elektrisch betriebenen Fahrzeugs, beispielsweise eines Flurförderzeugs, ansteuern.

Die Gleichspannung kann aus einer Batterie oder einem Generator als Gleichspannungsquelle bereitgestellt werden. Als Generator kann ein Gleichspannungsgenerator oder ein Drehstromgenerator eingesetzt werden, dessen erzeugter Drehstrom in einem Gleichrichter gleichgerichtet wird.

Aus der EP 1 083 599 B1 ist ein Umrichter bekannt, bei dem der elektrische Gleichspannungszwischenkreis von einer Leiterplatte gebildet ist, die oberhalb eines Leistungsmoduls angeordnet ist. Das Leistungsmodul besteht aus mehreren identisch aufgebauten rechteckförmigen Substraten, die an den Längsseiten mit elektrischen Kontaktflächen versehen sind. Die Substrate werden nebeneinander derart angeordnet, dass zwei nebeneinander liegende Kontaktflächen zweier benachbarter Substrate auf demselben Potential liegen und durch eine Anpressvorrichtung in Form von elektrisch leitenden Druckstücken elektrisch kontaktiert werden. Die Druckstücke dienen weiterhin zur Anpressung der Substrate mit der den Leistungshalbleitern gegenüberliegenden Unterseite an einen Kühlkörper, um die Substrate mit dem Kühlkörper in thermischen Kontakt zu bringen und eine Kühlung der Leistungshalbleiter sicherzustellen.

Durch die Anordnung der Druckstücken an den Längsseiten der rechteckförmigen Substrate ist die Anpressung der Substrate des Leistungsmoduls auf den Kühlkörper auf die Längsbereich der Substrate beschränkt. Durch Erlahmen der Druckkräfte der Druckstücke bei Dauer- oder Wechsellastbetrieb des Umrichters kann es zu einer ungenügenden Anpressung der Substrate an dem Kühlkörper und aufgrund einer Verringerung des thermischen Kontakts zu einer ungenügenden Kühlung des Leistungsmoduls kommen.

Aus der EP 0 711 107 B1 ist ein gattungsgemäßer Umrichter bekannt, bei dem eine Leiterplatte des Leistungsmodul mit einer den Leistungshalbleitern gegenüberliegenden Unterseite an einem Kühlkörper anliegt und mittels mindestens eines Befestigungsmittels mit dem Kühlkörper in thermischen Kontakt bringbar und an dem Kühlkörper befestigt ist. Die Befestigungsmittel sind von Verschraubungen gebildet, die in den Kühlkörper eingeschraubt sind und über Metallhülsen als Distanzstücke weiterhin eine über der Leiterplatte des Leistungsmoduls angeordnete Platine haltern. Die Verschraubungen sind bei diesem Umrichter im inneren Bereich des rechteckförmigen Aufbaus angeordnet, so dass die Leiterplatte im Bereich der Verschraubungen und des Anlagebereichs der Distanzstücke auf den Kühlkörper geklemmt und verpresst wird. Aufgrund der Anordnung der Distanzstücke und der Verschraubungen im inneren Bereich der rechteckförmigen Leiterplatte des Leistungsmoduls kann ein vollflächiges Anliegen der Leiterplatte mit der Unterseite auf dem Kühlkörper im Betrieb des Umrichters nicht sichergestellt werden, so dass es zu einer Verringerung des thermischen Kontakts mit dem Kühlkörper und zu einer ungenügenden Kühlung des Leistungsmoduls kommen kann.

Aus der WO 2003/034467 A2 ist ein Druckrahmen bekannt, der eine Leiterplatte mit Leistungshalbleitern auf einen Kühlkörper andrückt.

Aus der DE 199 42 915 A1 sind Leistungshalbleiter bekannt, die auf der Oberseite eines isolierenden und thermisch leitenden Substrats angeordnet sind. Durch eine Anpressvorrichtung werden die Leistungshalbleiter angedrückt und elektrisch kontaktiert.

Aus der DE 195 28 632 A1 ist ein Steuergerät bekannt, bei dem die Auflagefläche eines Gehäusebodens auf einer Leiterplatte größer ist als die entsprechende Auflagefläche des Gehäusedeckels und Leistungsbausteine in diesem Bereich auf der Leiterplatte angeordnet sind, um Wärme in den Gahäuseboden abzuführen.

Aus der WO 2006/027040 A1 ist ein Kühlkörper mit einer darauf angeordneten Leiterplatte mit Leistungsbausteinen bekannt, die durch einen umlaufenden Druckrahmen angepresst wird.

Aus der US 2009/168358 A1 ist ein Leistungsumrichter für einen Motor bekannt, bei dem die Leistungsmodule einzeln gegen den Kühlkörper gedrückt werden.

Der vorliegenden Erfindung liegt die Aufgabe zugrunde, einen Umrichter der eingangs genannten Gattung zur Verfügung zu stellen, bei dem mit geringem Bauaufwand ein vollflächiges Anliegen der Leiterplatte an dem Kühlkörper erzielt werden kann und ein verbesserter thermischer Kontakt der Leiterplatte mit dem Kühlkörper erzielbar ist.

Diese Aufgabe wird durch einen Umrichter mit den Merkmalen des Patentanspruchs 1 gelöst. Der Gedanke besteht darin, zusätzlich zu den Befestigungsmitteln, mit denen die Leiterplatte mit dem Kühlkörper in thermischen Kontakt gebracht und mit der den Leistungshalbleitern gegenüberliegenden Unterseite auf den Kühlkörper gepresst wird, einen Druckrahmen vorzusehen, mit dem eine zusätzliche Anpressung der Leiterplatte auf dem Kühlkörper erzielbar ist. Das Leistungsmodul erwärmt sich aufgrund der Abwärme der Leistungshalbleiter im Betrieb, wodurch ein Bi-Metall-Effekt auftritt, der zu einem Abheben der Leiterplatte vom Kühlkörper führen kann. Mit dem Druckrahmen kann ein derartiges Abheben des Leistungsmoduls von dem Kühlkörper vermieden werden. Mit einem derartigen Druckrahmen kann somit mit geringem Bauaufwand eine zusätzliche Anpressung des Leiterplatte auf den Kühlköper in den Bereichen erzielt werden, die von den Befestigungsmitteln nicht oder nicht ausreichend erfasst werden, so dass ein vollflächiges Anpressen der Leiterplatte auf dem Kühlkörper erzielt wird. Mit einem derartigen Druckrahmen kann mit geringem Bauaufwand ein vollflächiges Verpressen und Verklemmen der Leiterplatte auf dem Kühlkörper erzielt und ein Abheben der Leiterplatte von dem Kühlkörper wirksam vermieden werden, wodurch ein verbesserter thermischer Kontakt der Leiterplatte mit dem Kühlkörper und somit eine verbesserte Kühlung des Umrichters im Betrieb erzielt wird.

Der Druckrahmen steht mit dem Umfang der Leiterplatte in Wirkverbindung. Bei einem Umrichter, bei dem die Befestigungsmittel im inneren Bereich der Leiterplatte des Leistungsmoduls angeordnet sind und der Umfang der Leiterplatte von den Befestigungsmitteln nicht ausreichend erfasst wird, kann mit dem Druckrahmen mit geringem Bauaufwand eine umfangsseitige Verpressung und Verklemmung der Leiterplatte auf dem Kühlkörper erzielt werden, wodurch bei dem Umrichter ein vollflächiges Verpressung und Anliegen der Leiterplatte auf dem Kühlkörper sichergestellt werden kann und ein Abheben der Leiterplatte des Leistungsmoduls am Außenumfang sicher vermieden werden kann, so dass der thermische Kontakt verbessert und eine wirksame Kühlung erzielt werden kann.

Der Druckrahmen ist mit mindestens einer Haltenase, insbesondere einer rahmenförmig umlaufenden Haltenase, versehen, die mit der Oberseite der Leiterplatte an deren Außenumfang zusammenwirkt. Mit einem derartigen Druckrahmen kann mittels der Haltenase mit geringem Bauaufwand die Leiterplatte am Umfang auf den Kühlkörper gepresst und mit dem Kühlkörper verklemmt werden.

Der Druckrahmen ist mittels einer Schraubverbindung an dem Kühlkörper befestigbar, wodurch mit geringem zusätzlichem Montageaufwand und Bauaufwand eine Befestigung des Druckrahmens an dem Kühlkörper und somit eine umfangsseitige Anpressung des Leistungsmoduls an dem Kühlkörper erzielt wird.

Es ist ein den Umrichter abdeckender Deckel vorgesehen, der mittels der Schraubverbindungen als Befestigungsmittel an dem Druckrahmen befestigbar ist. Die Schraubverbindungen des Druckrahmens erfüllen somit eine Doppelfunktion zur Befestigung des Druckrahmens an dem Kühlkörper und zur Befestigung des Deckels an dem Druckrahmen, so dass sich der Montageaufwand und der Bauaufwand des erfindungsgemäßen Umrichters weiter verringern lassen.

Die Befestigungsmittel können hierbei über den Umfang des Druckrahmens verteilt werden. Hinsichtlich eines geringen Montageaufwands ergeben sich Vorteile, wenn die Befestigungsmittel jeweils in einem Eckbereich oder den Stirn- und/oder Längsseiten des Druckrahmens angeordnet sind. Hierdurch kann mit einer geringen Anzahl, beispielsweise von entsprechenden Verschraubungen, gebildeten Befestigungsmitteln ein umfangsseitiges Verpressen der Leiterplatte an dem Kühlkörper mittels des Druckrahmens erzielt werden.

Bei derartigen Umrichtern ist als weitere Randbedingung ein möglichst induktivitätsarmer Aufbau erwünscht. Das Schalten der Leistungshalbleiter des Leistungsmoduls wird durch Streuinduktivität, die aus den Weglängen des mechanischen Aufbaus zwischen einem Gleichstromzwischenkreis und den Leistungshalbleitern des Leistungsmoduls resultieren, erschwert. Diese Streuinduktivität verschlechtert das Schaltverhalten der Leistungshalbleiter und kann zu Überspannungen, die zu einer Zerstörung der Leistungshalbleiter führen können, und erhöhten Schaltverlusten führen. Ursache ist die in der Streuinduktivität, durch großes di/dt erzeugte Selbstinduktionsspannung, welche sich der Zwischenkreisspannung überlagert und zu unzulässig hohen Spannungen und entsprechenden Spannungsspitzen an den Leistungshalbleitern führen kann.

Weitere Vorteile und Einzelheiten der Erfindung werden anhand der in den schematischen Figuren dargestellten Ausführungsbeispiele näher erläutert. Hierbei zeigt
- Figur 1: eine perspektivische Explosionsdarstellung des erfindungsgemäßen Umrichters,
- Figur 2: den Umrichter in einer weiteren Explosionsdarstellung,
- Figur 3: einen Schnitt entlang der Linie A-A der Figur 1,
- Figur 4: einen Schnitt entlang der Line B-B der Figur 1 mit angebauter Stromschiene und Kühlkörper und
- Figur 5: eine Detailansicht des Umrichters mit einem umfangsseitig angeordneten Druckrahmen.

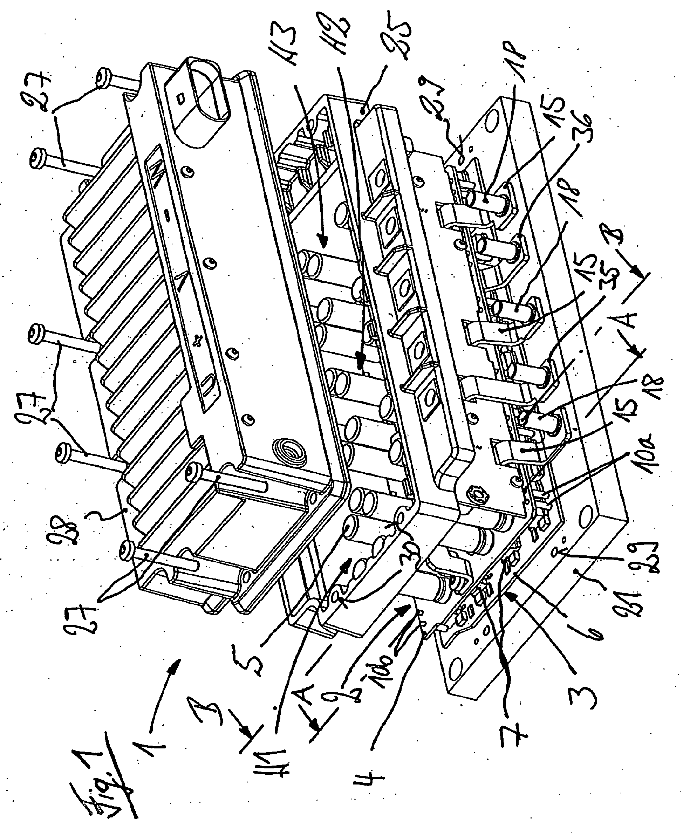

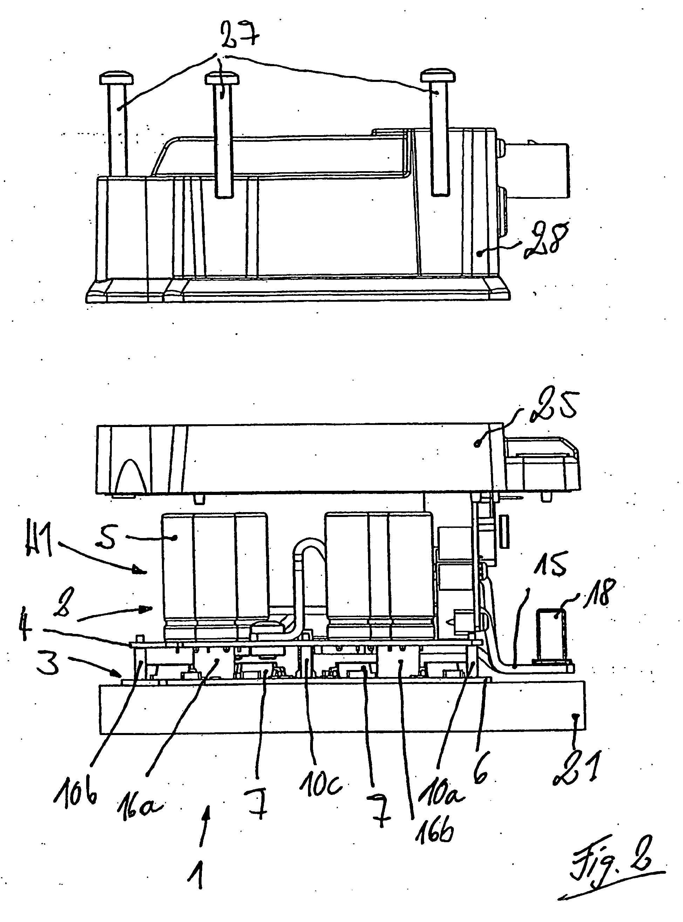

In den Figuren 1 und 2 ist ein Umrichter 1, beispielsweise ein dreiphasiger Drehstromumrichter als Frequenzumrichter, zur Ansteuerung eines elektrischen Motors dargestellt.

Der Umrichter 1 weist einen Gleichspannungszwischenkreis 2 und ein Leistungsmodul 3 auf. Der Gleichspannungszwischenkreis 2 ist von einer plattenförmigen Platine 4 gebildet, die mit Kondensatoren 5 versehen ist. Das Leistungsmodul 3 ist von einer Leiterplatte 6, bevorzugt einer IMS-Leiterplatte, gebildet, die mit Leistungshalbleitern 7, beispielsweise Leistungstransistoren, und weiteren diskreten Bauteilen bestückt ist.

Der erfindungsgemäße Umrichter 1 weist einen Aufbau mit drei identischen Halbbrücken H1, H2, H3 auf, die jeweils von mehreren Leitungshalbleitern 7 gebildet werden können.

Die Leistungshalbleiter 7 des Leistungsmoduls 3 sind jeweils mit einem Minuspol und einem Pluspol des Gleichspannungszwischenkreises 2 verbunden. Die Leistungshalbleiter 7 einer Halbbrücke H1 bzw. H2 bzw. H3 sind jeweils zu einem der drei stromführenden Motorphasenausgänge zusammengeschlossen.

Bei dem erfindungsgemäßen Umrichter 1 sind die Platine 4 des Gleichspannungszwischenkreises 2 und die Leiterplatte 6 des Leistungsmoduls 3 sandwichartig übereinander angeordnet, wobei die Platine 4 des Gleichspannungszwischenkreises 2 direkt oberhalb der Leiterplatte 6 des Leistungsmoduls 3 in einer weiteren parallelen Ebene angeordnet ist. Zur elektrischen Kontaktierung und mechanischen Verbindung des Gleichspannungszwischenkreises 2 und des Leistungsmoduls 3 sind mehrere oberflächenmontierte Lötstifte 10a, 10b, 10c vorgesehen.

In den Figuren 1 und 2 ist weiterhin ein Kühlkörper 21, ein Druckrahmen 25 und ein Deckel 28 dargestellt, die später genauer beschrieben werden.

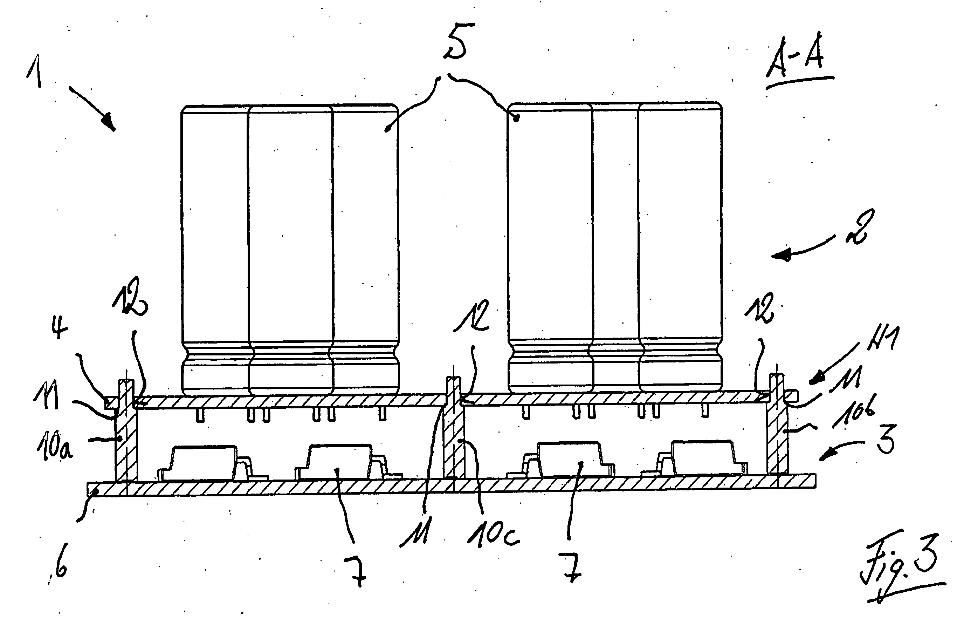

Wie aus der Figur 3 ersichtlich ist, sind die Lötstifte 10a bzw. 10b hierbei an den Außenseiten, beispielsweise den Längsseiten, des Umrichters 1 symmetrisch angeordnet, wobei die Lötstifte 10a und 10b beispielsweise den Pluspol bilden. In einer Längsmittelebene des Umrichters 3 sind weitere Lötstifte 10c angeordnet, die beispielsweise den Minuspol bilden.

Zur elektrischen Kontaktierung einer Steuerleitung der Leistungshalbleiter 7 in der Leiterplatte 6 des Leistungsmoduls 3 können nicht näher dargestellte Steckverbindungen vorgesehen werden.

Die Lötstifte 10a, 10b, 10c sind an der Oberseite der Leiterplatte 6 des Leistungsmodul 3 angeordnet und in der Leiterplatte 6 bestückt, bevorzugt mit der Leiterplatte 6 verlötet, wodurch diese mit entsprechenden stromführenden Leiterbahnen der Platine 6 elektrisch kontaktiert sind und an der Leiterplatte 6 befestigt sind. Die Lötstifte 10a, 10b, 10c weisen am oberen Ende einen Durchmesserabsatz 11 auf, wobei sich die Lötstifte 10a, 10b, 10c mit dem verringerten Durchmesser durch eine an den Durchmesser der Lötstifte angepasste Aufnahmebohrung 12 der Platine 4 des Gleichspannungszwischenkreises 2 erstrecken. Hierdurch kann die Platine 4 mit geringem Montageaufwand auf die oberflächenmontierten Lötstifte 10a, 10b, 10c mit den Aufnahmebohrungen 12 aufgesteckt werden und an den Durchmesserabsätzen 11 der Lötstifte 10a, 10b, 10c im Abstand zu der Leiterplatte 6 gehalten werden. Durch Verlöten der Lötstifte 10a, 10b, 10c mit entsprechenden Leiterbahnen der Platine 4 des Gleichstromzwischenkreises 2 kann die elektrische Kontaktierung der Lötstifte 10a, 10b, 10c mit der Platine 4 und die mechanische Verbindung der Platine 4 mit der Leiterplatte 6 auf einfache Weise hergestellt werden.

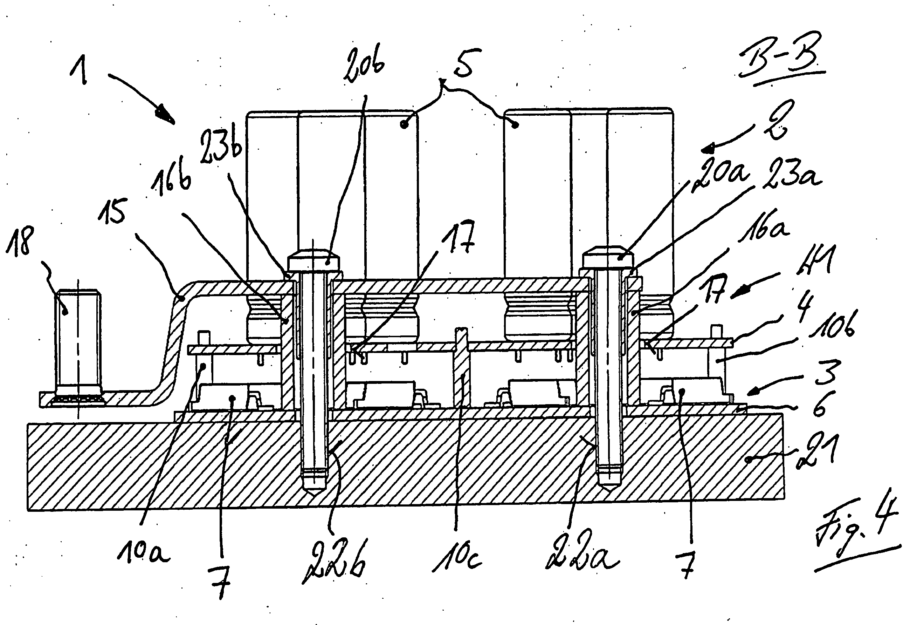

Die drei Phasenabgänge der Motorphasen und somit die Leistungsstromanschlüsse des erfindungsgemäßen Umrichters 1 werden - wie aus der Figur 1 ersichtlich ist - von jeweils einer streifenförmigen Stromschiene 15 gebildet, von denen in der Figur 4 der Phasenabgang der Halbbrücke H1 dargestellt ist. Die Phasenabgänge der Halbbrücken H2 und H3 sind - wie aus der Figur 1 ersichtlich ist - identisch aufgebaut.

Die von einem flachstahlförmigen, beispielsweise Kupfer- oder Stahlbauteil, gebildete Stromschiene 15 ist bei dem erfindungsgemäßen Umrichter 1 oberhalb der Platine 4 des Gleichspannungszwischenkreises 2 in einer weiteren parallelen Ebene angeordnet und steht mittels mindestens eines von einer Hülse gebildeten elektrisch leitenden Metallkörpers 16a, 16b mit den Ausgängen der zugeordneten Leistungshalbleiter 7 der entsprechenden Halbbrücke H1, H2 bzw. H3 in Verbindung. Die Stromschienen 15 sind hierbei innerhalb der Höhenerstreckung der Kondensatoren 5 des Gleichspannungszwischenkreises 2 angeordnet.

Die Platine 4 des Gleichspannungszwischenkreises 2 ist zur isolierenden Durchführung der Metallkörper 16a, 16b mit jeweils einer entsprechenden bohrungsförmigen Ausnehmung 17 versehen, deren Durchmesser größer als der Außendurchmesser der Hülsen ist. Die von den Hülsen gebildeten Metallkörper 16a, 16b stehen hierbei mit der unteren Stirnseite mit stromführenden Leiterbahnen der Leiterplatte 6 des Leistungsmoduls 3 in Kontakt. Auf die obere Stirnseite der von den Hülsen gebildeten Metallkörper 16a, 16b ist die entsprechende Stromschiene 15 aufgesetzt.

Wie in Verbindung mit der Figur 1 ersichtlich ist, sind die Stromschienen 15 zwischen den Kondensatoren 5 der jeweiligen Halbbrücke H1, H2, H3 angeordnet und an dem in der Figur 4 linken Seite aus dem Umrichteraufbau seitlich herausgeführt und an dem herausragenden Ende mit einem Anschluss 18, insbesondere einem Bolzen, für einen Leistungsstromabgriff als Motorphasenabgang versehen.

In dem seitlich herausgeführten Bereich ist die Stromschiene 15 nach unten in Richtung der Platine 4 und der Leiterplatte 6 abgekröpft, um eine platzsparende Anordnung der Anschlüsse 18 innerhalb der Höhenerstreckung des Umrichters 1 zu erzielen.

Zur Befestigung der Stromschiene 15 auf den Metallkörpern 16a, 16b ist jeweils ein, beispielsweise als Verschraubung ausgebildetes Befestigungsmittel 20a, 20b vorgesehen, mit der die Stromschiene 15 an den Metallkörpern 16a, 16b befestigt und elektrisch kontaktiert wird. Die Metallkörper 16a, 16b sind hierbei bevorzugt mit der Leiterplatte 6 des Leistungsmoduls 3 verlötet. Das von der Verschraubung gebildete Befestigungsmittel 20a, 20b ist hierbei in einer Aufnahmebohrung der Hülse konzentrisch zu der Hülse angeordnet.

In der Figur 4 ist weiterhin der Kühlkörper 21 des erfindungsgemäßen Umrichters 1 dargestellt, auf dem die Leiterplatte 6 des Leistungsmoduls 3 zu dessen Kühlung mit der den Leistungshalbleitern 7 gegenüberliegenden Unterseite aufliegt.

Bei dem erfindungsgemäßen Umrichter 1 weisen die Befestigungsmittel 20a, 20b eine Doppelfunktion auf und dienen neben der Verpressung der Stromschienen 15 mit den Metallkörpern 16a, 16b und somit der Funktion Befestigung der Stromschienen 15 und elektrischer Kontaktierung der Motorphasenabgänge weiterhin zur Funktion Befestigung und Verpressung des Leistungsmoduls 3 auf dem Kühlkörper 21.

Die Befestigungsmittel 20a, 20b sind hierbei jeweils von elektrisch isolierten Schrauben gebildet, die sich durch die von den Hülsen gebildeten Metallkörper 16a, 16b erstrecken und in entsprechende Gewindeaufnahmen 22a, 22b des Kühlkörpers 21 eingeschraubt werden können. Zur Isolation der Befestigungsmittel 20a, 20b ist jedes Befestigungsmittel 20a, 20b mit einer Isolationshülse 23a, 23b versehen, die zwischen dem Schraubenkopf des als Verschraubung ausgebildeten Befestigungsmittels 20a, 20b und der Oberseite der Stromschiene 15 eingespannt ist und sich nach unten in die Hülse erstreckt, um den Schraubenkopf und den Schraubenschaft des als Verschraubung ausgebildeten Befestigungsmittels 20a, 20b gegenüber der Stromschiene 15 und dem entsprechenden Metallkörper 16a bzw. 16b elektrisch zu isolieren.

Durch das Verschrauben der Befestigungsmittel 20a, 20b in dem Kühlkörper 21 können weiterhin von den Befestigungsmittel 20a, 20b die Metallkörper 16a, 16b mit der unteren Stirnseite an die stromführenden Leiterbahnen der Leiterplatte 6 alternativ zu einer Lötverbindung gepresst werden, wodurch von den Befestigungsmittel 20a, 20b zusätzlich die elektrische Kontaktierung der Metallkörper 16a 16b mit der Leiterplatte 6 des Leistungsmoduls 3 und somit die elektrische Kontaktierung der Motorphasenabgänge erzielt wird.

Wie aus der Figur 1 ersichtlich ist, erfolgt der Anschluss des Gleichspannungszwischenkreises 2 an den Pluspol und den Minuspol ebenfalls über streifenförmigen Stromschiene 35, 36, die im Aufbau den Stromschienen 15 der drei Motorphasenabgänge ähnlich sind. Die beispielsweise den Pluspol bildenden Stromschiene 35 ist hierbei zwischen den Kondensatoren der benachbarten Halbbrücken H1 und H2 angeordnet. Die den Minuspol bildenden Stromschiene 36 ist zwischen den Kondensatoren der benachbarten Halbbrücken H2 und H3 angeordnet. Die Stromschienen 35, 36 sind zur selben Seite wie die Stromschienen 15 seitlich aus dem Umrichteraufbau herausgeführt und in dem seitlich herausgeführten Bereich ebenfalls nach unten in Richtung der Platine 4 und der Leiterplatte 6 abgekröpft, um eine platzsparende Anordnung der entsprechenden Anschlüsse des Pluspols und Minuspols innerhalb der Höhenerstreckung des Umrichters 1 zu erzielen.

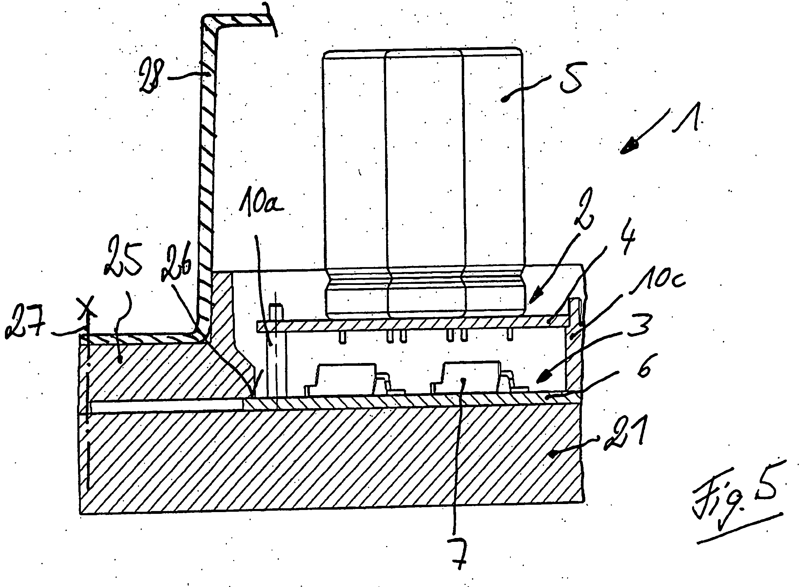

Durch die Befestigungsmittel 20a, 20b und die von den Hülsen gebildeten Metallkörper 16a, 16b kann eine flächige Verpressung der Leiterplatte 6 auf den Kühlkörper 21 um den Bereich der Hülsen im inneren Bereich der Leiterplatte 6 erzielt werden. Um bei einer Erwärmung des Leistungsmoduls 3 ein Abheben des Leiterplatte 6 von dem Kühlkörper 21 zu vermeiden, ist der erfindungsgemäße Umrichter 1 - wie in der Figur 5 dargestellt ist - mit dem Druckrahmen 25 zur zusätzlichen Anpressung des Leistungsmoduls 3 an dem Kühlkörper 21 versehen, um ein vollflächiges Anliegen der Leiterplatte 6 auf dem Kühlkörper 21 sicherzustellen.

Der Druckrahmen 25 steht hierbei mit dem Außenumfang der Leiterplatte 6 des Leistungsmodul 3 in Wirkverbindung und ist mit mindestens einer entsprechenden, insbesondere einer rahmenartig umlaufenden, Haltenase 26 versehen, die mit der Oberseite der Leiterplatte 6 an deren Außenumfang zusammenwirkt. Die Haltenase 26 an dem rahmenartigen Druckrahmen 25 kann hierbei im Bereich der drei Stromschienen 15 sowie der Stromschienen 35, 36 unterbrochen sein. Die Befestigung des Druckrahmens 25 an dem Kühlkörper 21 und somit die zusätzliche umfangsseitige Verpressung des Leistungsmoduls 3 auf den Kühlkörper 21 kann über die in den Figuren 1 und 2 näher dargestellten Schraubverbindungen 27 erfolgen, die sich durch Durchgangsbohrungen 30 des Druckrahmens 25 erstrecken und in entsprechende Gewindebohrungen 29 des Kühlkörpers 21 eingeschraubt werden können.

Über die Befestigungsmittel 27 kann weiterhin - wie in den Figuren 1, 2 und 5 dargestellt ist - ein Deckel 28 an dem Druckrahmen 25 befestigt werden, der den Umrichter 1 nach oben abdeckt. Die Befestigungsmittel 27 sind bevorzugt an den Eckbereichen bzw. den Stirn- und/oder Längsseiten des rahmenartig umlaufenden Druckrahmens 25 angeordnet, vodurch mit einer geringen Anzahl von Befestigungsmitteln 27 und einem entsprechend geringen Montageaufwand ein umfangsseitiges Verpressen der Leiterplatte 6 auf dem Kühlkörper 21 und gegebenenfalls eine Befestigung des Deckels 28 erzielt wird.

Der erfindungsgemäße Umrichter 1 weist eine Reihe von Vorteilen auf. Durch die Anordnung der Platine 4 des Gleichspannungszwischenkreise 2 direkt oberhalb der Platine 6 des Leistungsmoduls 3 und die Verwendung von oberflächenmontierten Lötstiften 10a, 10b, 10c zur elektrischen und mechanischen Verbindung des Leistungsmoduls 3 mit dem Gleichspannungszwischenkreis 2 kann der Abstand des Leistungsmoduls 3 von dem Gleichspannungszwischenkreis 2 minimiert werden, um einen verbesserten induktionsarmen Aufbau mit minimierten Streuinduktivitäten zu erzielen. Die Lötstifte 10a, 10b, 10c können vollautomatisch bestückt werden, wodurch der Monatageaufwand vermindert wird. Die Doppelfunktion der Lötstifte 10a, 10b, 10c zur mechanischen und elektrischen Verbindung des Gleichspannungszwischenkreises 2 mit dem Leistungsmodul 3 ergibt einen einfachen und kostengünstigen Aufbau. Die Stromschienen 15, die an den Metallkörpern 16a, 16b befestigt und über die Metallkörper 16a, 16b an der Leiterplatte 6 befestigt und mit der Leiterplatte 6 elektrisch kontaktiert sind, ermöglich eine platzsparende und stabile Ausführung der Motorphasenabgänge bei einem geringen Bauaufwand und Montageaufwand. Durch die elektrisch isolierten Befestigungsmittel 20a, 20b und deren Doppelfunktion können die Motorphasenabgänge des Leistungsmoduls 3, die von den Stromschienen 15 und den Metallkörper 16a, 16b gebildet werden, und die mechanische Befestigung des Leistungsmoduls 3 an dem Kühlkörper 21 mit geringem Herstellaufwand in kostengünstiger Weise realisiert werden, wobei weiterhin eine einfache Montage erzielt wird. Die Anordnung der Stromschienen 15 oberhalb der Platine 4 des Gleichspannungskreises 2 zwischen den Kondensatoren 5 des Gleichspannungszwischenkreises ermöglicht eine platzsparende Anordnung der Motorphasenabgänge mit einem geringen Bauraumbedarf des erfindungsgemäßen Umrichters 1 und erleichtert über die gute Zugänglichkeit der Befestigungsmittel 20a, 20b die Montage des erfindungsgemäßen Umrichters 1 weiter. Gleiches gilt für die Anordnung und Befestigung der den Pluspol und den Minuspol bildenden Stromschienen 35, 36. Über den erfindungsgemäßen Druckrahmen 25 ist mit geringem Bauaufwand neben den Befestigungsmitteln 20a, 20b eine zusätzliche umfangsseitige Anpressung des Leistungsmoduls 3 an dem Kühlkörper 21 zur wirksamen Kühlung des Umrichters 1 erzielbar. In Verbindung mit den im inneren Bereich der Leiterplatte 6 angeordneten Befestigungsmittel 20a, 20b kann mit dem Druckrahmen 25 eine vollflächiges Anliegen der Leiterplatte 6 auf dem Kühlkörper 21 erzielt und sichergestellt werden und ein Abheben der Leiterplatte 6 von dem Kühlkörper 21 verhindert werden. Über die Befestigungsmittel 27 des Druckrahmens 25 kann weiterhin ein den Umrichter 1 abdeckender Deckel 28 auf einfache Weise an dem Druckrahmen 25 befestigt werden. Durch den erfindungsgemäßen mechanischen Aufbau des Umrichters 1 können einfache und kostengünstige Löttechnologien verwendet werden, wodurch die Herstellung weiter vereinfacht und verbilligt wird.

## Patentansprüche

1. Umrichter zur Speisung von elektrischen Antriebsmaschinen aus einer Gleichspannungsquelle, als mehrphasiger Freuquenzumrichter, mit einem mindestens einen Leistungshalbleiter aufweisenden Leistungsmodul und einem Kühlkörper, wobei das Leistungsmodul von einer Leiterplatte gebildet sind, die mit einer den Leistungshalbleitern gegenüberliegenden Seite an einem Kühlkörper anliegt und mittels mindestens eines Befestigungsmittels, insbesondere einer Verschraubung, mit dem Kühlkörper in thermischen Kontakt bringbar und an dem Kühlkörper befestigt ist,
**dadurch gekennzeichnet,**
**dass** zur zusätzlichen Anpressung der Leiterplatte (6) an dem Kühlkörper (21) ein Druckrahmen (25) vorgesehen ist, der mit mindestens einer Haltenase (26), insbesondere einer rahmenförmig umlaufenden Haltenase (26), versehen ist, die mit der Oberseite der Leiterplatte (6) an deren Außenumfang zusammenwirkt, und dass der Druckrahmen (25) mittels Schraubverbindungen (27) und Durchgangsbohrungen (30) in dem Druckrahmen (25) außerhalb des Außenumfangs der Leiterplatte (6) an dem Kühlkörper befestigt ist, wobei ein den Umrichter (1) abdeckender Deckel (28) vorgesehen ist, der ebenfalls mittels der Schraubverbindungen (27) an dem Druckrahmen (25) befestigt ist.

2. Umrichter nach Anspruch 1
**dadurch gekennzeichnet,**
**dass** der Druckrahmen (25) mit dem Umfang der Leiterplatte (6) in Wirkverbindung steht.

3. Umrichter nach Anspruch 1 oder 2
**dadurch gekennzeichnet,**
**dass** die Schraubverbindungen (27) jeweils in einem Eckbereich oder den Stirn- und/oder Längsseiten des Druckrahmen (25) angeordnet ist.

## Claims

1. Converter for feeding electrical drive machines from a DC voltage source, in the form of a polyphase frequency converter, having a power module, which has at least one power semiconductor, and a heat sink, wherein the power module is formed by a printed circuit board which bears against a heat sink by way of a side which is situated opposite the power semiconductors, and can be brought into thermal contact with the heat sink and is fastened to the heat sink by means of at least one fastening means, in particular a screw joint, **characterized in that** a pressure frame (25) is provided for additionally pressing the printed circuit board (6) against the heat sink (21), the said pressure frame being provided with at least one retaining lug (26), in particular a retaining lug (26) which runs around the said pressure frame in the manner of a frame and interacts with the top face of the printed circuit board (6) at its outer circumference, and **in that** the pressure frame (25) is fastened to the heat sink by means of screw connections (27) and passage bores (30) in the pressure frame (25) outside the outer circumference of the printed circuit board (6), wherein a cover (28) which covers the converter (1) is provided, the said cover likewise being fastened to the pressure frame (25) by means of the screw connections (27).

2. Converter according to Claim 1, characterized the to top in that the pressure frame (25) is operatively connected to the circumference of the printed circuit board (6).

3. Converter according to Claim 1 or 2, **characterized in that** the screw connections (27) are each arranged in a corner region or the end sides and/or longitudinal sides of the pressure frame (25).

## Revendications

1. Convertisseur pour l'alimentation de machines d'entraînement électriques à partir d'une source de tension continue, en tant que convertisseur de fréquence polyphasé, comprenant au moins un module de puissance présentant des semi-conducteurs de puissance et un corps de refroidissement, le module de puissance étant formé par une carte à circuits imprimés qui s'applique par un côté opposé aux semi-conducteurs de puissance contre un corps de refroidissement et qui peut être amenée en contact thermique avec le corps de refroidissement et qui peut être fixée au corps de refroidissement au moyen d'au moins un moyen de fixation, en particulier d'un vissage,
**caractérisé en ce que**
pour le pressage supplémentaire de la carte à circuits imprimés (6) contre le corps de refroidissement (21), il est prévu un cadre de pression (25) qui est pourvu d'au moins un ergot de retenue (26), en particulier d'un ergot de retenue (26) périphérique en forme de cadre qui coopère avec le côté supérieur de la carte à circuits imprimés (6) au niveau de sa périphérie extérieure, et **en ce que** le cadre de pression (25) est fixé au corps de refroidissement au moyen de connexions vissées (27) et d'alésages traversants (30) dans le cadre de pression (25) à l'extérieur de la périphérie extérieure de la carte à circuits imprimés (6), un couvercle (28) recouvrant le convertisseur (1) étant prévu, lequel est également fixé au cadre de pression (25) au moyen des connexions vissées (27).

2. Convertisseur selon la revendication 1, caractérisé la jusqu'en haut en ce que le cadre de pression (25) est en liaison fonctionnelle avec la périphérie de la carte à circuits imprimés (6).

3. Convertisseur selon la revendication 1 ou 2, **caractérisé en ce que**
les connexions vissées (27) sont disposées à chaque fois dans une région de coin ou dans les côtés frontaux et/ou les côtés longitudinaux du cadre de pression (25).
